# EUROPEAN PATENT SPECIFICATION

(11) **EP 0 730 397 B1**
(45) Date of publication and mention of the grant of the patent: **07.04.1999**
(21) Application number: 96106676.8
(22) Date of filing: 05.11.1993
(51) Int. Cl.: H05K 13/08, H05K 13/04

(54) **Method for mounting components on a substrate and components mounting machine therefor**
Verfahren zur Befestigung von Bauelementen auf einem Substrat und Bestückungsmaschine hierfür
Procédé pour monter des composants sur un substrat et machine de montage de composants pource faire

(30) Priority: 05.11.1992 JP 296124/92
(43) Date of publication of application: 04.09.1996
(62) Divisional of application: 93118009.5
(73) Proprietor: YAMAHA HATSUDOKI KABUSHIKI KAISHA, Iwata-shi Shizuoka-ken, 438 (JP)
(72) Inventor: Onodera, Hitoshi, Iwata-shi, Shizuoka-ken (JP)
(74) Representative: Grünecker, Kinkeldey, Stockmair & Schwanhäusser Anwaltssozietät

(56) References cited:
- EP-A- 0 416 878
- US-A- 5 131 139

## Description

The present invention relates to a method for mounting a minute component onto a substrate, said component being attracted by means of an attracting nozzle disposed on a head unit and is investigated as to its attracted state through a component attracted state detecting system, said detecting system comprising a photographing means. Moreover, the present invention relates to a component mounting machine for mounting such components, preferably for performing the afore-indicated method.

For mounting minute component such as I.C's, resistors, transisters, condensers, etc., exactly on their specified positions on the substrate, such as a printed circuit board, mounting apparatuses were already suggested which attract a component through an attracting nozzle by vacuum and detecting the attracting position of the component in view of irregularities which can prevent the component from being precisely positioned on the desired spot onto the substrate. Such component mounting apparatuses are, for example, disclosed in the applicant's previous European patent applications No. 93111932.5, 93110535.7, 93110547.2 and 93110537.3 which all belong to the prior art under Article 54(3) EPC.

Therefore, so far a chip component mounting machine has already been suggested on which a chip component, such as a electronic component like I.C., etc., is attracted from a component feeding section by a mounting head unit of the machine, transfered to a prepositioned substrate such as a printed circuit board and is mounted at a predetermined position thereon. Such a mounting machine usually has a head unit adapted for moving in the X-axis and Y-axis directions and at least one attracting nozzle adapted for moving in a Z-axis vertical direction. Moreover, the attracting nozzle is rotatable about its vertical R-axis and the head unit is provided with a driving means for movement in various directions and for rotating the attracting nozzle. By controlling these driving means and supply means for applying a negative pressure to the attracting nozzle, the chip component is automatically attracted and mounted.

As the attracting position of the component as attracted to the attracting nozzle tends to imply some undesirable deviations, it is required to correct the mounting position according to the position of deviations of the component and, therefore, it has already been suggested to equip the mounting machine with an optical detecting means composed of a parallel light beam emitting section and a light receiving section for emitting parallel light beams toward the component and detecting the attracted state of the component on the basis of the projection of the component (see EP93110547.2).

In some cases difficulties have arisen with said system as the components to be attracted and mounted have many lead pins projected therefrom which render sometimes a clear detection by the article detecting means difficult.

Moreover, further problems may arise from the fact that it is desirable to provide the head unit with a plurality of attracting nozzles for improving the efficiency of the production. Depending on the size of the components which require recognition it is either desirable to attract and mount components by all of a plurality of attracting nozzles or by using only one or as selected number thereof. Moreover, attention is to be paid to avoid any interference between the components and the attracted state detecting means.

Document EP-A-416 878 discloses a method for mounting minute components onto a substrate and a component mounting machine according to the prior art portions of claims 1 and 6.

From this document it is already known to utilise a camera based component detecting system in order to investigate the plan view of the attracted state of the component. In this case, however, the detecting accuracy is low as the detected image is susceptible to, for example, interfering light reflected at the attracting nozzle or at the lead pins. According to said known camera detection the accuracy shall be increased by reducing the visual field, so that only part of the component is imaged. This leads to a time consuming detection procedure which is again not free from any troubles caused by the surrounding light conditions.

Therefore, it is an objective of the present invention to provide a method for mounting minute components onto a substrate as indicated above which allows a more appropriate approach of the attracted state detection particularly recognising a clear photographic image of the component to be investigated and instantaneously to be mounted.

Moreover, it is a further objective of the present invention to provide an improved component mounting machine as indicated above, particularly adapted for performing said method, having an improved detecting system for evaluating the attracted state of the component, said detecting system enabling to meet photograph based detecting requirements substantially free from interference factors in accordance with the type of the component the attracted state of which is to be investigated.

In order to perform the afore-indicated objective in terms of the method, the present invention provides a method for mounting a minute component onto a substrate as defined in claim 1.

The method includes positioning a photographing assisting means around the attracting nozzle, said photographing assisting means at least partially constitutes a background for the component while same is photographed.

Thus, a well defined background for the component is provided and any interference with light reflected at the nozzle or the head unit is avoided.

According to a preferred embodiment of said method the component attracted state is detected by means of a component recognising camera of said photographing means which is directed to a lower side of said component and a light beam emitting unit of said photographing assisting means is directed to an upper side of said component particularly facing said component recognising camera. Accordingly, by lightening the upper side of the component while imaging the lower side of the component contrast conditions are increased, so that the attracted state of the component is clearly imaged.

Preferably, the detection of the component attracted state by the component recognising camera comprises raising of a first and second attracting nozzles by respective vertical said axis servo motors, moving the light beam emitting unit of the photographing assisting means in a first photographing assisting position, moving the head unit by operating Y- axis and X- axis servo motors to the component mounting position and lowering the first attracting nozzle only through the associated Z- axis servo motor to insert the first attracting nozzle into the through hole of the light beam emitting unit to attract a chip component, then raising the first nozzle until the chip component attracted to the first attracting nozzle reaching a height lower then that of the light beam emitting unit appropriate for photographing while the head unit is moved then to a position above the component recognising camera and, on the light emission through the light beam emitting unit, the component is photographed by the component recognising camera. Thus, the photographing assisting means is only utilised in cases where the component recognising camera constitutes the actual detecting system. The photographing assisting means is moved at the side of the nozzle in the non-operated condition, so that a second attracting nozzle is mounted close to the first attracting nozzle.

According to the invention, a main processor of said main controller selects one of said component recognising camera in response to components having lead pins and a the second detecting means on the basis of a laser unit in response to other types of components to be mounted.

Further preferred developments of the method according to the present invention are laid down in the further subclaims.

The afore-indicated objective is performed in terms of the component mounting machine as defined in claim 6. Said machine includes a photographing assisting means which at least partially constitutes a background for photographing the components and, said photographing assisting means having a through hole for accommodating therein the attracting nozzle.

Preferably, said photographing assisting means is disposed on the head unit, said photographing assisting means comprises a moveable light beam emitting unit having a plate like light emitter composed of a plurality of LED's, a diffusing plate positioned on the light emitter adapted to emit diffused light in the direction to the component and said photographing means being disposed behind the component, while photographing same and a mounting member for combing the light image at the diffusing plate.

Moreover, according to yet another preferred embodiment of the present invention said photographing means as a component recognising camera disposed on a base of the machine said component recognising camera being directed to a lower side of the component opposite to said photographing assisting means for photographing said component.

As an alternative embodiment of the present invention said light emitting unit of said photographing assisting means being disposed on a base of the machine and a reflector plate installed on the head unit at least partially constitutes the background for photographing said component.

Further preferred embodiments of the component mounting machine according to this invention are laid down in the other subclaims.

With the afore-indicated method and components mounting machine, in its most developed state including all preferred embodiments thereof, when a series of operations of component attraction, attracted state detection, component mounting, etc., are carried out, it is decided which of the photographing means and the optical detecting means is to be used for detecting the component attracted state according to the kind of the component. When the photographing means is used, a preferably provided photographing assisting member constitutes a background for photographing by being brought to the position for component photographing, and, in this state, a through hole of the photographing assisting member allows the first attracting nozzle to move up and down, and a chip component is attracted and mounted by the first attracting nozzle. On the other hand, when the optical detecting means is used, a chip component is attracted and mounted preferably also by the second attracting nozzle with the photographing means kept away from the nozzle installing portion.

Further, if the preferably provided photographing assisting member is provided with a light emitter and is adapted for being moved to the position for photographing the substrate when photographing the substrate by the substrate photographing means installed on the head unit, a light emitter preferably installed on the photographing assisting means is used for lighting both when photographing the component and for photographing the substrate.

In the following the present invention is explained in greater detail through an embodiment thereof in conjunction with the accompanying drawings, wherein:
Figure 1 is an overall plan view of a component mounting machine according a preferred embodiment of this invention, having detecting means for investigating a component attracted state,
Figure 2 is a front view of the component mounting machine of Figure 1,
Figure 3 is an enlarged front view of a head unit of the component mounting machine of Figures 1 and 2,
Figure 4a and 4b show the state of the head unit in the case where a component recognising camera is used for detecting the component attracted state with Figure 4a being a schematic front view and Figure 4b being a schematic plan view,
Figures 5a and 5b show the state of a head unit in the case where a laser unit is used for detecting the component attracted state with Figure 5a being a schematic front view and Figure 5b being a schematic plan view,
Figure 6a and 6b show the state of a head unit while recognising a substate with Figure 6a being a schematic front view and Figure 6b being a schematic plan view,
Figure 7 is a block diagram of a control system of the component mounting machine of Figure 1,
Figure 8 is a flow chart showing the control in the case where a component recognising camera is used for detecting the attracted state of the component,
Figure 9 is a flow chart showing the control in the case where a laser unit is used for detecting the attracted state of the component,
Figure 10 is a flow chart showing the control for recognising a substrate.

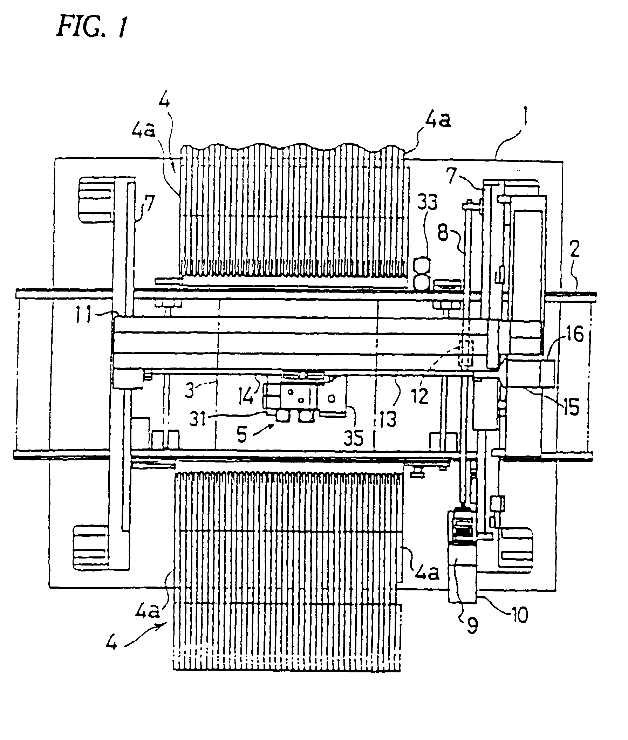

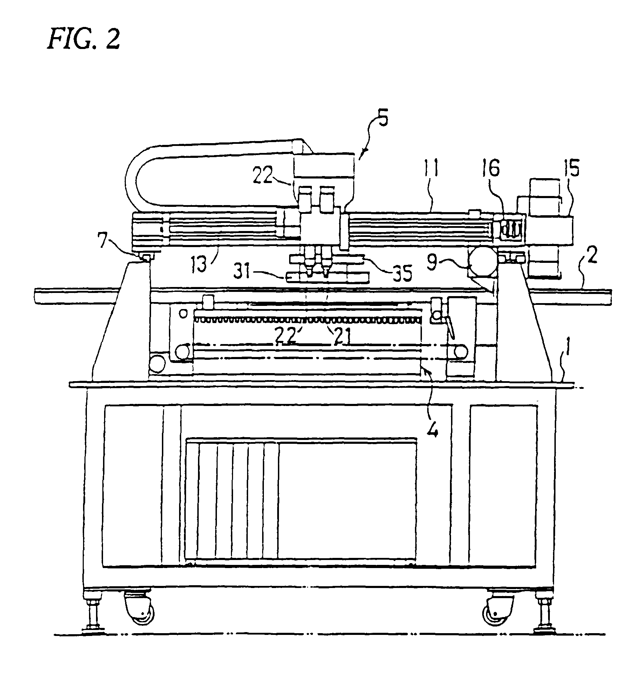

An embodiment of this invention is described referring to appended drawings. Fig.1 and Fig.2 show the overall structure of a component mounting machine, an embodiment of this invention. As shown, a conveyer 2 for conveying printed substrates is inastalled on the base 1, the printed substrate is conveyed on the conveyer 2, and is brought to a stop at a predetermined component mounting position.

On the sides of the conveyer 2 are disposed component feeding sections 4 each provided with many rows of tape feeders 4a. Each tape feeder 4a is adapted for sending out a tape holidng and containing chip components 20 such as I.C's, transisters, condensers, etc., at regular intervals from a reel, and is provided with a ratchet type feeder mechanism incorporated at the tape send-out end so that the feeder tape 4a may be intermittently sent out as chip components are picked up by a hand unit 5 to be described later.

The head unit 5 adapted for moving both in the X axis direction (direction of the conveyer 2) and in the Y axis direction (direction perpendiclar to the X axis direction on a horizontal plane) is installed above the base 1.

That is, while a pair of fixed rails 7 extended in the Y axis direction and a ball screw 8 to be rotated by a Y axis servomotor 9 are disposed on the base 1, a head unit support member 11 is supported on the fixed rails 7, and a nut portion 12 provided on the support member 11 is in screw-engagement with the ball screw 8. The supporting member 11 is provided with a guide member 13 extended in the X-axis direction and a ball screw 14 to be rotated by an X axis servomotor 15, a head unit 5 is movably supported by said guide member 13, and a nut portion (not shown) provided in this head unit 5 is in screw-engagement with the ball screw 14. While the ball screw 8 is rotated by the operation of the Y axis servomotor 9 and the support member 11 is moved in the Y axis direction, the ball screw 14 is rotated by the operation of the X axis servomotor 15 and the head unit 5 is moved in the X axis direction relative to the support member 11.

The Y axis servomotor 9 and X axis servomotor 15 are respectively provided with position detecting means 10 and 16 each constituted of an encoder.

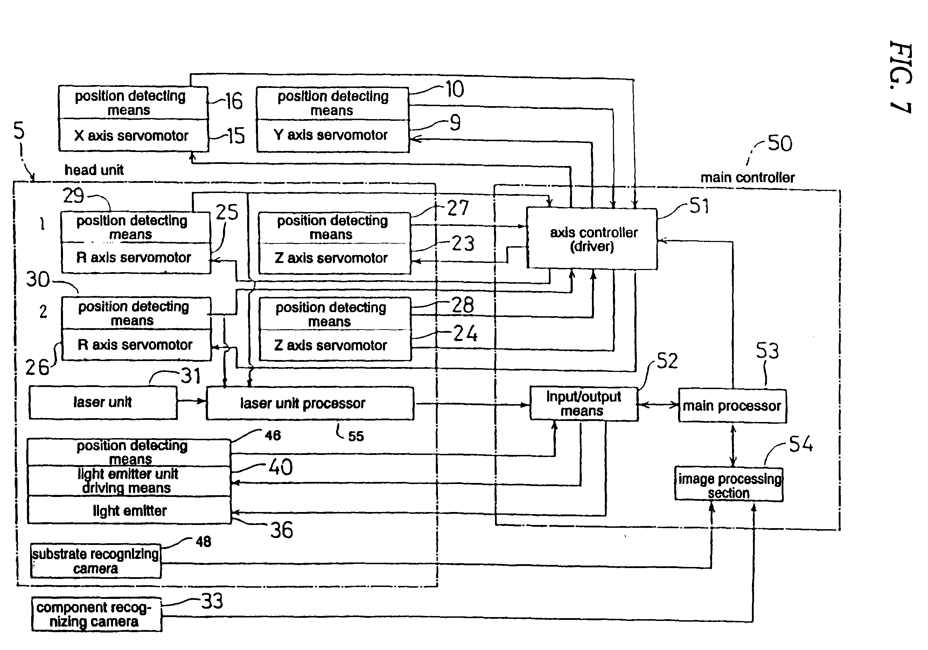

The head unit 5 is provided with first and second attracting nozzles 21, 22. While this head unit is provided with a laser unit 31 as optical detecting means for detecting the attracted state of the chip components on the basis of the projection, a component recognizing camera 33 (see Fig. 7) as photographing means is installed at a suitable position within the head unit moving range on the base 1. Further, the head unit 5 is equipped with a light emitter unit 35 as a photographing assisting member and a substrate recognizing camera 48 as substrate photographing means.

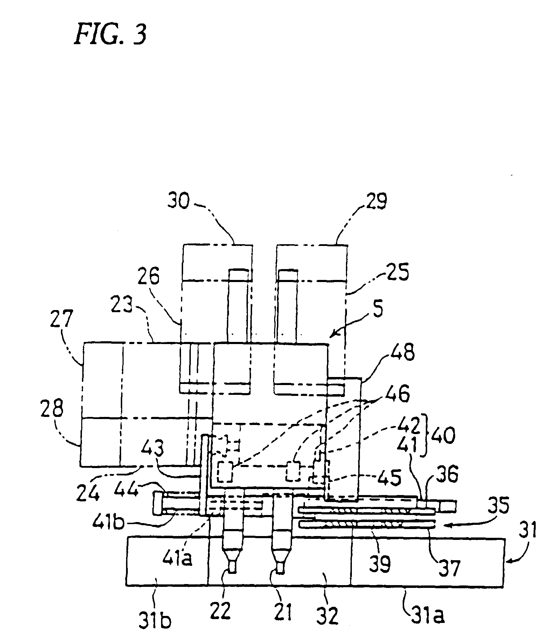

Concretely describing members equipped on the head unit 5 referring to Fig.3, both attracting nozzles 21,22 are made capable of moving in the Z axis direction (up-down direction) and rotating about the R axis (nozzle center axis), and are operated by the Z axis servomotors 23,24 and R axis servomotors 25,26. Each servomotor 23 through 26 is provided with a positiion detecting means 27 through 30, respectively. Each attracting nozzle 21,22 is connected with a negative pressure supplying means (not shown) through valves, etc., so that component attracting negative pressure may be supplied to the attracting nozzles when required.

The first attracting nozzle 21 is used for component attraction in both cases where the component attracted state is detected by the laser unit 31 and where the component attracted state is detected by the component recognizing camera 33, and is disposed generally at the center of the space corresponding to the space 32 in the laser unit 31. The second attracting nozzle 22 is used for component attraction only in the case where the component attracted state is detected by the laser unit 31, and is disposed slantly on one side of the first nozzle 21.

On the lower end portion of tee head unit 5 is installed the laser unit 31. This laser unit 31 has a laser beam generating section (parallel beam emitting section) 31a and a detector (light receiving section) 31 disposed opposite to each other on both sides of a space 32 through which the attracting nozzles 21,22 passes when raised and lowered, and the detector 31b is constituted of a CCD.

The light emitter unit 35 is disposed on the lower portion of the head unit 5 above the laser unit 31. This light emitter unit 35 has a plate-like light emitter 36 composed of a number of LEDs, a diffusing plate 37 positioned under the light emitter 36 and a mounting member 38 for combining these 36 and 37. The diffusing plate constitutes a background for photographing the chip component attracted to the attracting nozzle 21, and is constructed with milk white acril plates, etc., so that the light from the light emitter 36 may be diffused.

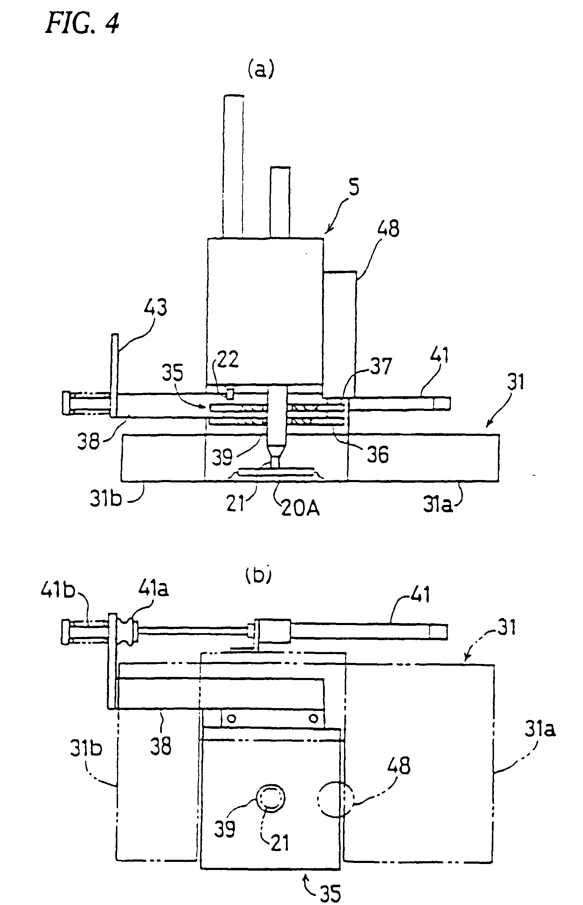

This light emitter unit 35 is mounted so as to be movable in the lateral direction relative to the head unit 5 (left-right direction in Fig.3). The light emitter unit 35 has a through hole 39 bored through both light emitter 36 and diffusing plate 37 at the position corresponding to the first attracting nozzle 21 while the light emitter unit is at the first position (See Fig.4) so that the first attracting nozzle 21 may be inserted therein.

Light emitter unit driving means 40 is provided to move the light emitter unit 35, and is constructed with a first cylinder 41 and a second cylinder 42. To the tip end portion of the rod of the first cylinder 41 are connected an expanded portion 41a and a shaft portion 41b. A bracket 43 is connected to the mounting member 38 of the light emitter unit 35 and is movably coupled with the shaft portion 41b, and is pushed against the expanded portion 41a by the urging force of a spring 44. Further, the extended potion of this bracket 43 is positioned opposite to the tip end of the rod of the second cylinder 42.

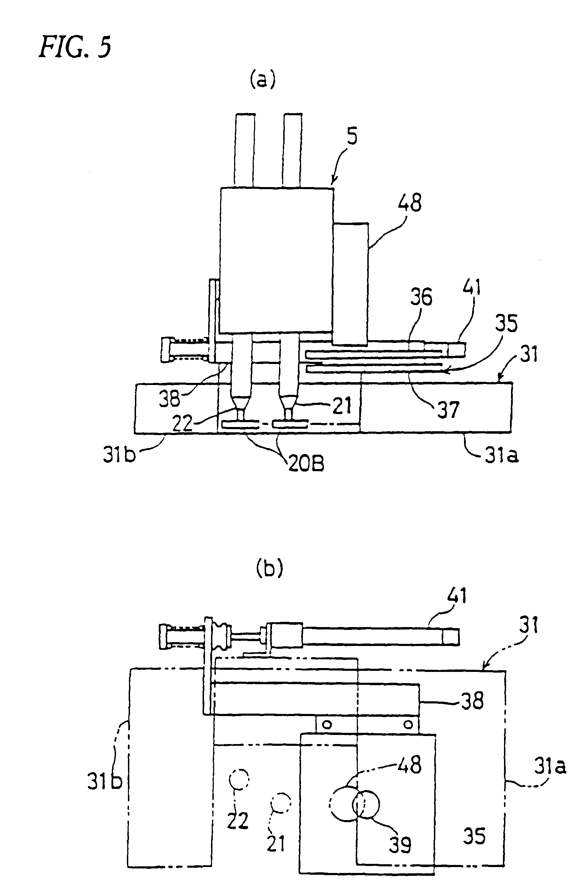

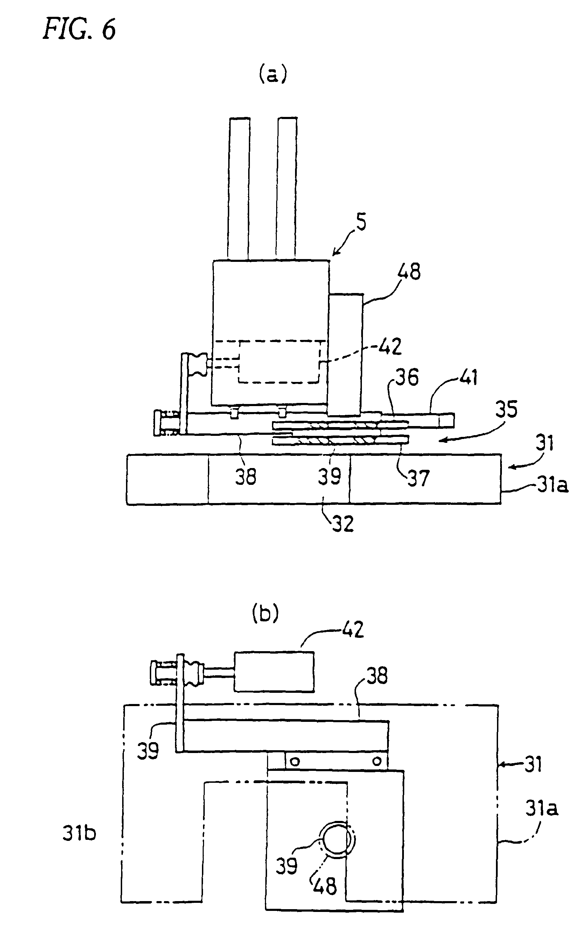

When the first cylinder 41 is actuated and its rod is pushed out, the light emitter unit 35 is moved to its first position (component photographing position) at which the light emitter unit 35 covers the nozzle installiing portion from below. When the first cylinder 41 is actuated and its rod is pulled in, and the second cylinder is also in the state having its rod pulled in, the light emitter unit 35 is moved to the second position (optical detecting means operating position) away from the nozzle installing portion as shown in Figs.5(a) and 5(b). Further, when the first cylinder 41 is in the state having its rod pulled in and the second cylinder is in the state having its rod pushed out, the light emitter unit 35 is moved to the third position (substrate photographing position) at whifh the through hole 39 corresponds to the substrate photographing camera 48 as shown in Figs.6(a) and 6(b).

To detect these three positions, the head unit 5 is provided with position detecting means composed of three sensors for detecting a dog 45 provided on the light emitter unit 35 at each of the positions above.

Fig.7 shows an embodimnt of the control system. In this diagram, the Y axis servomotor 9, X axis servomotor 15, Z axis servomotors 23,24 and R axis servomotors 25,26 for attracting nozzles 21,22 of the head unit 5, and position detecting means 10,16,27 through 30 provided on these servomotors are electrically connected to the axis controller (driver) 51 of the main controller 50. The laser unit 31 is electrically connected to the laser unit processor 55, which is connected to the main processor 53 through the input/output means 52 of the main controller 50. Further, position detecting means 46, light emitter unit driving means 40 and light emitter 36 for the light emitter unit 35 are connected to the input/output means 52.

The substrate recognizing camera 48 equipped on the head unit 5 and the component recognizing camera 33 installed on the Case 1 of the mounting machine are connected to the image processing section 54 provided in the main controller 50. The image processing section 54 reads the image of the chip component taken by the component recognizing camera 39 and processes the image as specified to detect the center position and rotating angle, etc., of the chip component when the chip component attracted state is detected on the basis of the image taken by the component recognizing camera 33. Further, the image processing section 54 reads the image sent from the substrate recognizing camera 48 and processes the image as specified to detect the mark attached on the substrate 3 when recognizing the substrate to detect the position of the substrate 3.

The main processor 53 selects one from the laser unit 31 and the component recognizing camera 33 so as to be used for detecting the component attracted state according to the kind, etc.. of the components while controlling the operations of servomotors 9,15,23 through 26 through the axis driver 51 so that attraction and mounting of components may be automatically carried out, and controls according to this selection. That is. the laser unit is selected when the component attracted state can be detected by the laser unit 31 and the component recognizing camera 33 is selected for a component the attracted state of which is difficult to be detected by the laser unit 31, for example. for chip components having many lead pins projecting therefrom, and processes for detecting the component attracted state and controls the light emitter unit driving means 40 according to such selection.

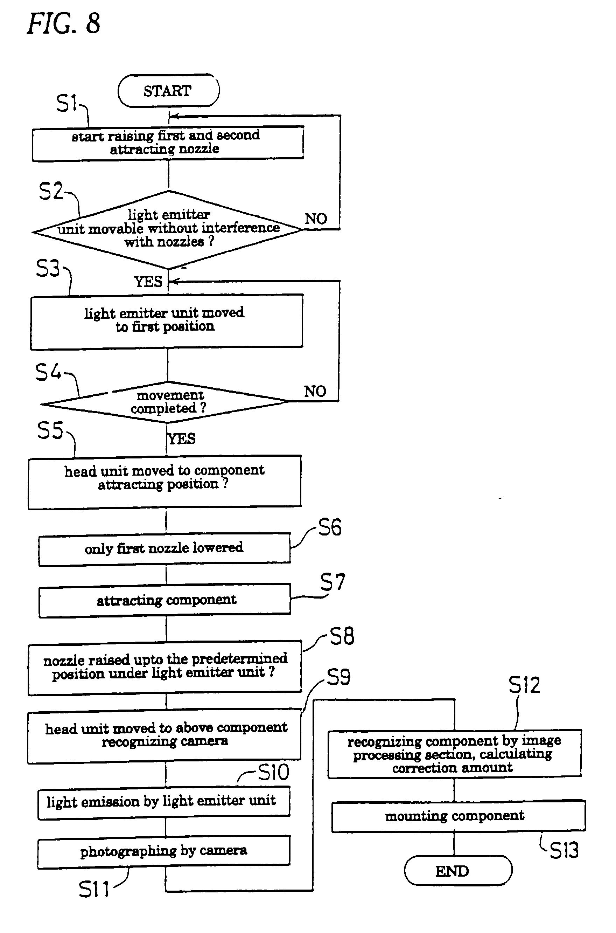

The control by the main controller 50 is described referring to Figs.4 through 6 on the basis of flow charts of Figs.8 through 10.

Fig.8 shows a routine for detecting the component attracted state by the component recognizing camera. In this routine, at the step S1, the first and second attracting nozzles are raised by the Z axis servomotors 23,24. At the step S2, it is decided whether both nozzles 21,22 were raised into the range where the light emitter unit 35 is movable without interfering with both nozzles 21,22 or not, and, when this decision is yes, the light emitter unit 35 is moved to the first position at the step S3. Then, when it is decided that the movement of the light emitter unit 35 has been completed at the step S4, the head unit 5 is moved to the component mounting position by the Y axis and X axis servomotors 9 and 15 at the step S5, and only the the first attracting nozzle 21 is lowered by the Z axis servomotor at the step S6. In this case, since the through hole 39 is at the position corresponding to the first attracting nozzle 21 when the light emitter unit 35 is at the first position, the first nozzle 21 can be lowered through the through hole 39.

After lowering above, a chip componet is attracted to the first attracting nozzle 21 at the step S7. Then, while the first attracting nozzle 21 is raised until the chip component attracted to the first attracting nozzle 21 reaches a height lower than the light emitter unit 35 and appropriate for photographing at the step S8, the head unit 5 is moved to a position above the component recognizing camera 33 at the step S9.

Then, the light emitter unit 35 emits light at the step S10, and the chip component is photographed by the component recognizing camera 33 at the steo S11. At the step S12, the chip component is recognized, the component attracted state is detected and the correction amount is obtained by the image processing section 54. As the process here,the image of the chip component is scanned at the image processing section 54, the center position and the rotating angle about the R axis of the chip component are obtained on the basis of this scanning, and the correction amounts in the X, Y and rotational directions are obtained from the positional deviation of the component center point relative to the component attracting point of the attracting nozzle and the rotating angle deviation.

Next, the component is mounted at the step S13, that is, when the head unit is moved to a position above the substrate 3 and the attracting nozzle 21 reaches the corrected component mounting position, the attracting nozzle is lowered and the chip component is mounted on the substrate 3.

With such a process as shown in Fig.8, the light emitter unit 35 is brought to the first position to make it possible to recognize the component by photographing as shown also in Fig.4, only the first nozzle 21 among the attracting nozzles of the head unit 5 is used, and the chip component 20A is attracted and mounted by this attracting nozzle 21. In this case, since the through hole 39 is at the position corresponding to the first nozzle 21, the attracting nozzle 21 can be raised/lowered through this hole 39 to attract and mount a chip component. Although the chip component 20A requiring component recognition by photographing is usually of larger size, if the first attracting nozzle 21 is disposed near the center of the domain corresponding to the space 32 above, there is no trouble even if the attacted component is of larger size.

After the component is attracted, the attracted state of the component is detected by image processing on the basis of the image obtained by the component recognizing camera 33. In this case, since the light emitter unit 35 constitutes a background for the chip component being photographed while functioning as a lighting, a clear image can be obtained.

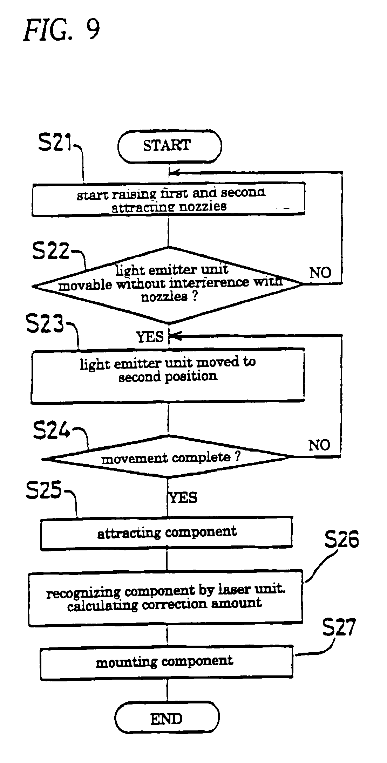

Fig.9 show the routine for detecting the component attracted state with the laser unit 31. In this routine, first, the first and second attracting nozzles 21,22 are raised at the step S21, and, at the step S22, it is decided whether both nozzles 21,22 were raised into the range where the light emitter unit 35 is movable without interfering with both nozzles 21,22 or not, and, when this decision is yes, the light emitter unit 35 is moved to the second position at the step S23. Then, when it is confirmed at the step S24 that the movement of the light emitter unit 35 has been completed, the component is attracted at the step S25; that is, while the head unit 5 is moved to the component attracting position, both first and second attracting nozzles 21,22 are actuated and a chip component is attracted to each of both nozzles.

Then, at the step S26, the component is recognized (component attracted state is detected) by the laser unit 31, and the correction amounts are obtained. As the process here, for example, while the chip components attracted to the attracting nozzles 21,22 are rotated in a state kept at a height position corresponding to the laser unit 31, laser beams are emitted from the laser beam generating section 31a, the projection width of the chip component is detected by the detector 31b receiving the laser beam above, and the correction amounts in the X axis, Y axis and rotational directions are obtained from the projection width, center point, rotation angle, etc., obtained at the position where the projection width becomes minimum. After this process, the components are mounted at the step S27.

With such a process as shown in Fig.9, the light emitter unit is moved to the second position where the light emitter unit does not interfere with the up/down movement or both attracting nozzles 21,22 as shown also in Fig.5, and the chip components 20B are attracted and mounted by both attracting nozzles 21,22.

After the components are attracted, the attracted states of the components are detected on the basis of the projection by the laser unit 31.

Since this process is continued also while the head unit 5 is moved from the component feeding section 4 to the position above the substrate, the overall production efficiency is elevated. The production efficiency is elevated also because both of first and second attracting nozzles 21,22 are used.

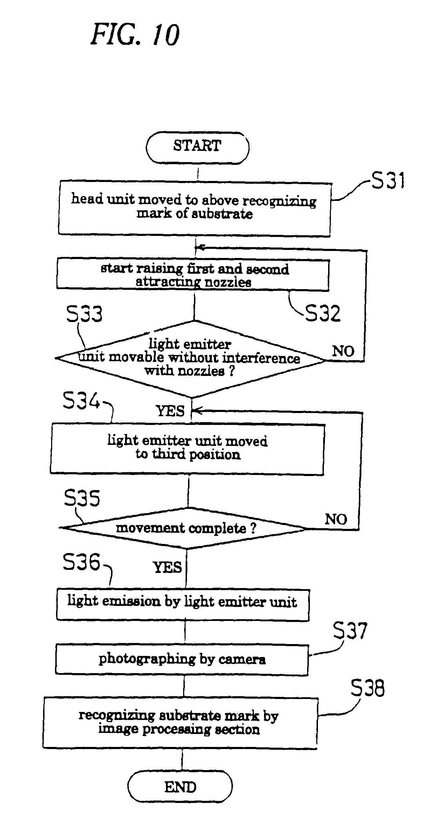

Fig.10 shows the routine for substrate recognizing process. In this routine, first, at the step S31, the head unit 5 is moved to a position above the recognizing mark attatched on the substrate. Then, the first and second attracting nozzles 21,22 are raised at the step S32, and it is decided whether both nozzles 21,22 has been raised into the range where the light emitter unit 35 can be moved without interference with both nozzles 21,22 or not at the step S33. When this decision is yes, the light emitter unit 35 is moved to the third position at the step S4. Then, when it is confirmed at the step S35 that the movement of the light emitter unit 35 has been completed, the light emitter unit emits light at the step S36, and the substrate 3 is photographed in this state by the substrate recognizing camera 48 at the step S37. Then, at the step S38, the mark attached on the substrate 3 is recognized by image processing at the image processing section 54, and its position is detected.

With such a substrate recognizing process as shown in Fig.10, the mark of the substrate 3 is investigated by the substrate recognizing camera 48 installed on the head unit 5. In this case, as shown also in Fig.6, the light emitter unit 35 is moved to the third position, and the through hole 39 is brought to the position corresponding to the substrate recognizing camera 48. In this state, the light emitter unit 35 is used as lighting for photographing the substrate 3.

The practical structure of this invention can be variously modified from the embodiment above. For example, although the embodiment above is equipped with a light emitter unit 35 having a light emitter 36 and a diffusing plate 37 on the head unit 5, another structure is possible in which the light emitter is installed on the base and a reflector plate is installed on the head unit so as to constitute a background for photographing the component.

Although the embodiment above is provided with one first attracting nozzle 21 and one second attracting nozzle 22, and only the first nozzle 21 is used when the component recognizing camera is used while both attracting nozzles 21 and 22 are used when the laser unit is used, two or more second nozzles may be used when the laser unit is used, and, in such a case, the first nozzle may be used exclusively for the case where the component recognizing camera is used. Still further, the mounting machine may be provided with a plurality of first nozzles.

Since the component attracted state detecting system for the component mounting machine according to this invention is provided, in addition to optical detecting means for detecting the component attracted state on the basis of the projection, with photographing means for detecting the component attracted state on the basis of the photograph means for detecting the component attracted state on the basis of the photograph image so that the photographing means and optical detecting means may be used selectively, and it is possible to appropriately use the photographing means and the optical detecting means for detecting the component attracted state selectively according to the kind of components.

Especially when the photographing means is used, the photographing assisting member may constitute a background for obtaining clear image while making the operation of the first nozzle possible.

On the other hand, when the optical detecting means is used, a series of operations such as attraction of chip components, detection of component attracted state, component mounting, etc., can be carried out efficiently in the state with the photographing assisting member kept away from the nozzle installing portion so that it may not interfere the operation of each attracting nozzle.

Preferably, the head unit is provided with a first and second attracting nozzles and is said photographing assisting member having a portion constituting a background when photographing and a through hole bored at a specific position and photographing assisting member driving means for moving the photographing assisting member to the position for the component photographing or to the position for the optical detecting means.

Further, if the head unit is provided with substrate photographing means, the photographing assisting member is provided with a light emitter, and the photographing assisting member is so constructed that the through hole thereof can be brought also to the position for substrate photographing corresponding to the substrate photographing means in this invention, the light emitter can be used for lighting both when photographing the component and when photographing the substrate, and the substrate can be photographed with a simple structure.

## Claims

1. Method for mounting minute components (20A,20B) onto a substrate (3), said components (20A,20B) being attracted by means of at least one attracting nozzle (21,22) disposed on a head unit (5) and investigated as to its attracted state by a component attracted state detecting system, said detecting system comprising a laser unit (31) as an optical detecting means and a photographing means (33,35), which are selectively used in dependence on the type of components (20A,20B) to be mounted, said photographing means comprising a component recognizing camera (33), said selection is made by a main processor (53) of a main controller (50), **characterized in that** said photographing means further comprising a movable photographing assisting means (35), said main processor (53) of said main controller (50) selects said component recognizing camera (33) when said components (20A,20B) to be mounted having lead pins and outputs a control signal to move said photographing assisting means (35) around said at least one nozzle (21) at this first photographing assisting position said photographing assisting means (35) at least partially constitutes a background for said component (20A,20B) while same is photographed, or said main processor (53) selects said laser unit (31) in dependence on other types of components (20) to be mounted.

2. Method according to claim 1, **characterized by** detecting a component attracted state means of said component recognizing camera (33) of said photographing means which is directed to a lower side of said component (20A) and directing a light beam emitting unit (36) of said photographing assisting means (35) to an upper side of said component (20A) particularly facing said component recognizing camera (33).

3. Method according to claims 1 or 2, **characterized in that** the detection of the component attracted state by the component recognizing camera (33) comprises raising of at least first and second attracting nozzles (21,22) by respective vertical Z-axis servo motors (23,24), moving the light beam emitting unit (36) of the photographing assisting means (35) in the first photographing assisting position, moving the head unit (5) by operating Y-axis and Z-axis servo motors (9,10) to the component mounting position and lowering the first attracting nozzle (21) only through the associated Z-axis servo motor (23) to insert the first attracting nozzle (21) into a through hole (39) of the light beam emitting unit (36) to attract a chip component (20), then raising the first nozzle (21) until the chip component (20A) attracted to the first attracting nozzle (21) reaching a height lower than that of the light beam emitting unit (36) appropriate for photographing while the head unit (5) is moved then to a position above the component recognizing camera (33) and, on the light emission through the light beam emitting unit (36), the component (20A) is photographed by the component recognizing camera (33).

4. Method according to claim 3, **characterized in that**, the component (20A) is recognized, the component attracted state is detected and a correction amount for positioning the component (20A) on the substrate is obtained by an image processing section (54) of the main controller (50).

5. Method according to claim 4, **characterized in that**, the photograph image of the component (20A) is scanned at the image processing section (54), a central position and a rotating angle about the R-axis of the component (20A) are obtained on the basis of said scanning and correction amount of the X,Y-axis and rotational directions are obtained from the positional deviation of a component center point relative to a component attracting point of the attracting nozzle (21) and a deviation of the rotating angle.

6. Component mounting machine comprising a movable head unit (5) supporting at least one attracting nozzle (21,22) for attracting by vacuum components (20A,20B) to be mounted at a predetermined position onto a substrate (3), in particular onto a printed circuit board, a component attracted state detecting system having a laser unit (31) as an optical detecting means and a photographing means (33,35), which are selectively usable in dependence on the type of components (20A,20B) to be mounted, said photographing means comprising a component recognizing camera (33), and a main controller (50) comprising a main processor (53) adapted to select the laser unit (31) or said component recognizing camera (33), in particular for performing the method as claimed in claim 1, characterized in that said photographing means further comprising a movable photographing assisting means (35), said main processor (53) is adapted to select said component recognizing camera (33), in case said components (20A) to be mounted having lead pins, and to output a control signal to move said movable photographing assisting means (35) such that a through hole (39) provided in said photographing assisting means (35) is positioned for accommodating said at least one nozzle (21), at this position said movable photographing assisting means (35) at least partially constituting a background for said component (20A) to be photographed, and that said main processor (53) is adapted to select said laser unit (31) in dependence on other types of components (20B) to be mounted.

7. Component mounting machine according to claim 6, **characterized in that** said photographing assisting means (35) is disposed on the head unit (5), said photographing assisting means (35) comprises a movable light beam emitting unit having a plate like light emitter (36) composed of a plurality of LED's, a defusing plate (37) positioned on the light emitter (36) adapted to emit defused light in a direction to the component (20A,20B) and said photographing means (33) being disposable behind the component while photographing same, and a mounting member (38) for combining the light emitter (36) and the defusing plate (37).

8. Component mounting machine according to claim 6 or 7, **characterized in that** said component recognizing camera (33) being disposed on a base (1) of the machine and being directable to a lower side of the component (20A) opposite to said photographing assisting means (35) for photographing said component (20A).

9. Component mounting machine according to claim 6, **characterized in that** said light emitting unit (36) of said photographing assisting means (35) being disposed on a base (1) of the machine and a diffusing plate (37) installed on the head unit (5) at least partially constitutes said background for photographing said component (20A).

10. Component mounting machine according to at least one of the preceding claims 6 to 9, **characterized in that** said head unit (5) comprises at least one first attracting nozzle (21) and at least one second attracting nozzle (22), said first attracting nozzle (21) being exclusively usable when said photographing means (35) is selected to detect the attracted state of the component (20A).

11. Component mounting machine according to at least one of the preceding claims 6 to 10, **characterized in that** a control system is provided comprising the main controller (50) having an axis controller driver circuit (51), input output means (52), the main processor (53) and an image processing section (54) connected to the component recognizing camera (33).

## Patentansprüche

1. Verfahren zum Montieren kleiner Bauteile (20A, 20B) auf ein Substrat (3), wobei die Bauteile (20A, 20B) durch wenigstens eine Ansaugdüse (21, 22), angeordnet an einer Kopfeinheit (5) angezogen werden und bezüglich ihres angezogenen Zustandes durch ein Bauteil-Anzugsstatus-Untersuchungssystem untersucht werden, wobei das Untersuchungssystem eine Lasereinheit (31) als eine optische Erfassungseinrichtung und eine Photographier-Einrichtung (33, 35) auweist, die wahlweise und in Abhängigkeit von dem Typus der zu montierenden Bauteile (20A, 20B) verwendet werden, wobei die Photographier-Einrichtung eine Bauteil-Erkennungs-Kamera (33) enthält und die Auswahl getroffen wird durch einen Hauptprozessor (52) einer Hauptsteuerung (50), dadurch gekennzeichnet, daß die Photographiereinrichtung weiterhin aufweist eine bewegliche Photographier-Hilfseinrichtung, daß der Hauptprozessor (53) der Hauptsteuerung (50) die Bauteil-Erkennungs-Kamera (33) auswählt, sobald die zu montierenden Bauteile (20A, 20B) Leiterstifte besitzen, und ein Steuersignal abgibt zum Bewegen der Photographier-Hilfseinrichtung (35) um die besagte wenigstens eine Düse (21), wobei an dieser ersten Photographier-Hilfsposition die Photographier-Hilfseinrichtung (35) zumindest teilweise einen Hintergrund für den Bauteil (20A, 20B) während dessen Photographierens konstituiert, oder der Hauptprozessor (53) die besagte Lasereinheit (31) in Abhängigkeit von anderen Typen von zu montierenden Bauteilen (20) auswählt.

2. Verfahren nach Anspruch 1, **gekennzeichnet durch** Detektieren einer Einrichtung eines Bauteil-Anzugsstatus mittels der Bauteil-Erkennungs-Kamera (33) der Photographiereinrichtung, welche Kamera auf eine untere Seite des Bauteils (20A) gerichtet ist, und Ausrichten einer Lichtstrahl-Emitter-Einheit (36) der Photographier-Hilfseinrichtung (35) auf eine obere Seite des Bauteils (20A) insbesondere zur besagten Bauteil-Erkennungs-Kamera (33) weisend.

3. Verfahren nach den Ansprüchen 1 oder 2, **dadurch gekennzeichnet,** daß die Erfassung des Bauteil-Anzugszustandes durch die Bauteil-Erkennungs-Kamera (33) das Anheben von wenigstens ersten und zweiten Anzugdüsen (21, 22) durch jeweilige Vertikal-Z-Achsen-Servormotoren (23, 24) umfaßt, ferner das Bewegen der Lichtstrahl-Emitter-Einheit (36) der Photographier-Hilfseinrichtung (35) in die erste Photographier-Hilfsposition, das Bewegen der Kopfeinheit (5) durch Betätigen von Y-Achsen und Z-Achsen-Servomotoren (9, 10) in die Bauteil-Montierposition und Absenken der ersten Ansaugdüse (21) nur durch den zugeordneten Z-Achsen-Servomotor (23) zum Einführen der ersten Ansaugdüse (21) in eine Durchgangsöffnung (39) der Lichtstrahl-Emitter-Einheit (36) zum Anziehen eines Chip-Bauteils (20), nachfolgendes Anheben der ersten Düse (21), bis der an der ersten Ansaugdüse (21) anhaftende Chip-Bauteil (20A) eine Höhe erreicht, die niedriger ist als die Höhe der Lichtstrahl-Emitter-Einheit (36) und die zum Photographieren geeignet ist, während die Kopfeinheit (5) anschließend zu einer Position oberhalb der Bauteil-Erkennungs-Kamera (33) bewegt ist, und unter Lichtemission durch die Lichtstrahl-Emittereinheit (36) der Bauteil (20A) durch die Bauteil-Erkennungs-Kamera (33) photographiert wird.

4. Verfahren nach Anspruch 3, **dadurch gekennzeichnet,** daß das Bauteil (20A) erkannt wird, der Bauteil-Anzugszustand erfaßt wird und ein Korrekturbetrag für die Positionierung des Bauteiles (20A) auf dem Substrat durch einen Bildverarbeitungsabschnitt (54) der Hauptsteuerung (50) bereitgestellt wird.

5. Verfahren nach Anspruch 4, **dadurch gekennzeichnet,** daß das Photographierbild des Bauteiles (20A) in dem Bildverarbeitungsabschnitt (54) eingelesen wird, und eine Mittelposition und ein Drehwinkel um die R-Achse des Bauteiles (20A) auf der Basis der eingelesenen und der Korrektur-Beträge der X-, Y- und Drehrichtungen aus der Positions-Ableitung eines Bauteil-Mittelpunktes relativ zu einem Bauteil-Anzugspunkt der Ansaugdüse (21) und einer Abweichung des Drehwinkels bereitgestellt werden.

6. Bauteil-Montage-Maschine mit einer beweglichen Kopfeinheit (5), die wenigstens eine Ansaugdüse (21, 22) lagert, um durch Vakuum in einer vorgegebenen Position auf ein Substrat (3) zu montierende Bauteile (20A, 20B) anzuziehen, insbesondere auf eine Leiterplatte zu montierende Bauteile, wobei die Kopfeinheit (5) ein Erfassunssystem zur Erfassung des Anzugszustandes der Bauteile aufweist, welches als eine optische Erfassungsenrichtung eine Lasereinheit (31) und eine Photographier-Einrichtung (33, 35) besitzt, die in Abhängigkeit vom Typ der zu montierenden Bauteile (20A, 20B) wahlweise einsetzbar sind, wobei die Photographier-Einrichtung eine Bauteil-Erkennungs-Kamera (33) umfaßt, und wobei eine Hauptsteuerung (50) vorgesehen ist, die einen Hauptprozessor (53) zum Auswählen der Laser-Einheit (31) oder der Bauteil-Erkennungs-Kamera (32) enthält, insbesondere zum Durchführen des Verfahrens gemäß Anspruch 1, **dadurch gekennzeichnet,** daß die Photographier-Einrichtung weiterhin eine bewegliche Photographier-Hilfseinrichtung (35) umfaßt, daß der Hauptprozessor (53) ausgebildet ist zum Auswählen der Bauteil-Erkennungs-Kamera (33) in dem Fall, daß die zu montierenden Bauteile (20A) Leiterstifte haben, und zum Ausgeben eines Steuersignals zum Bewegen der beweglichen Photographier-Hilfseinrichtung (35) derart, daß eine in der Photographier-Hilfseinrichtung (35) vorgesehene Durchgangsbohrung (39) positioniert wird zum Unterbringen der besagten wenigstens einen Düse (21), wobei die bewegliche Photographier-Hilfseinrichtung (35) an dieser Position zumindest teilweise einen Hintergrund für den zu photographierenden Bauteil (20A) konstituiert, und daß der Hauptprozessor (53) ausgebildet ist zum Auswählen der Laser-Einheit (31) in Abhängigkeit von anderen Typen von zu montierenden Bauteilen (20B).

7. Bauteil-Montage-Maschine nach Anspruch 6, **dadurch gekennzeichnet,** daß die Photographier-Hilfseinrichtung (35) an der Kopfeinheit (5) angeordnet ist und eine bewegliche Lichtstrahl-Emittereinheit umfaßt, welche einen plattenähnlichen Licht-Emitter (36) zusammengesetzt aus einer Vielzahl von LED's, und eine an dem Licht-Emitter (36) positionierte Diffusions-Platte (37) zum Emittieren diffusen Lichts in einer Richtung zum Bauteil (20A, 20B) umfaßt, und daß die Photographier-Einrichtung (33) beim Photographieren des Bauteils hinter dem Bauteil positionierbar ist, wobei die Photographier-Hilfseinrichtung (35) ein Montierglied (38) zum Kombinieren des Lichtemitters (36) und der Diffusionsplatte (37) umfaßt.

8. Bauteil-Montage-Maschine nach Anspruch 6 oder 7, **dadurch gekennzeichnet,** daß die Bauteil-Erkennungs-Kamera (33) an einer Basis (1) der Maschine angeordnet und zum Photographieren des Bauteils (20A) auf eine untere Seite des Bauteils (20A) gegenüberliegend zu der Photographier-Hilfseinrichtung (35) ausrichtbar ist.

9. Bauteil-Montage-Maschine nach Anspruch 6, **dadurch gekennzeichnet,** daß die Licht-Emittereinheit (36) der Photographier-Hilfseinrichtung (35) an einer Basis (1) der Maschine angeordnet ist, und daß eine an der Kopfeinheit (5) installierte Diffusionsplatte (37) zumindest teilweise den besagten Hintergrund zum Photographieren des Bauteils (20A) konstituiert.

10. Bauteil-Montage-Maschine nach wenigstens einem der vorhergehenden Ansprüche 6 bis 9, **dadurch gekennzeichnet,** daß die Kopfeinheit (5) wenigstens eine erste Ansaugdüse (21) und wenigstens eine zweite Ansaugdüse (22) aufweist, von denen die erste Anzugsdüse (21) exklusiv verwendbar ist, falls zum Erfassen des angezogenen Zustands des Bauteils (20A) die besagte Photographier-Einrichtung ausgewählt ist.

11. Bauteil-Montage-Maschine nach wenistense einem der vorhergehenden Ansprüche 6 bis 10, **dadurch gekennzeichnet,** daß ein Steuersystem vorgesehen ist, welches die Hauptsteuerung (50) mit einer Achsensteuerungs-Treiberschaltung (51), Eingabe/Ausgabe-Einrichtungen (52), den Hauptprozessor (53) und den mit der Bauteil-Erkennungs-Kamera (33) verbundenen Bildverarbeitungsabschnitt (54) umfaßt.

## Revendications

1. Procédé de montage de composant minuscule (20A, 20B) sur un substrat (3), lesdits composants (20A, 20B) étant attirés au moyen d'au moins une buse d'attraction (21, 22) disposée sur une unité de tête (5) et examinés, lorsqu'ils se trouvent à leur état attiré, par un système de détection d'état attiré de composant, ledit système de détection comprenant une unité laser (31), à titre de moyens de détection optiques, et des moyens photographiques (33, 35), qui sont sélectivement utilisés d'après le type de composants (20A, 20B) à monter, lesdits moyens photographiques comprenant une caméra de reconnaissance de composant (33), ladite sélection étant effectuée par un processeur principal (53) d'un pilote principal (50), caractérisé en ce que lesdits moyens photographiques comprennent en outre des moyens d'aide photographique (35) déplaçables, ledit processeur (53) dudit pilote principal (50) sélectionne ladite caméra de reconnaissance de composant (33) lorsque lesdits composants (20A, 20B) devant être montés ont des tiges conductrices et envoie un signal de commande pour déplacer lesdits moyens d'aide photographique (35) autour de ladite au moins une buse (21) dans cette première position d'aide photographique, lesdits moyens d'aide photographique (35) constituant au moins partiellement un arrière-plan pour ledit composant (20A, 20B), tandis que ce dernier est photographié, ou ledit processeur principal (53) sélectionne ladite unité laser (31) d'après d'autres types de composants (20) à monter.

2. Procédé selon la revendication 1, caractérisé par la détection de moyens d'état attiré de composant de ladite caméra de reconnaissance de composant (33) desdits moyens photographiques, qui sont orientés vers un côté inférieur dudit composant (20A), et par l'orientation d'une unité d'émission de faisceau lumineux (36) desdits moyens d'aide photographique (35) vers un côté supérieur dudit composant (20A), faisant face en particulier à ladite caméra de reconnaissance de composant (33).

3. Procédé selon la revendication 1 ou 2, caractérisé en ce que la détection de l'état attiré de composant, par la caméra de reconnaissance de composant (33), comprend le levage d'au moins des première et deuxièmes buses d'attraction (21, 22) par des servomoteurs d'axe (Z) vertical (23, 24) respectifs, déplaçant l'unité d'émission de faisceau lumineux (36) des moyens d'aide photographique (35) dans la première position d'aide photographique, déplaçant l'unité de tête (5) par actionnement de servomoteurs d'axe (Y) et d'axe (Z) (9, 10) vers la position de montage de composant et abaissant la première buse d'attraction (21) seulement via le servomoteur d'axe (Z) (23) associé, pour insérer la première buse d'attraction (21) dans un trou traversant (39) de l'unité d'émission de faisceau lumineux (36), pour attirer un composant de puce (20), levant ensuite la première buse (21) jusqu'à ce que le composant de puce (20A) attiré vers la première buse d'attraction (21) atteigne une hauteur inférieure à celle de l'unité d'émission de faisceaux lumineux (36) convenant pour la photographie, tandis que l'unité de tête (5) est déplacée ensuite vers une position se trouvant au-dessus de la caméra de reconnaissance de composant (33) et, lors de l'émission de lumière à travers l'unité d'émission de faisceaux lumineux (36), le composant (20A) est photographié par la caméra de reconnaissance de composant (33).

4. Procédé selon la revendication 3, caractérisé en ce que le composant (20A) est reconnu, l'état attiré de composant est détecté et une valeur de correction pour positionner le composant (20A) sur le substrat est obtenue par une section de traitement d'image (54) du pilote principal (50).

5. Procédé selon la revendication 4, caractérisé en ce que l'image photographique du composant (20A) est balayée au niveau de la section de traitement d'image (54), une position centrale et un angle de rotation autour de l'axe (R) du composant (20A) sont obtenus d'après ledit balayage et la valeur de correction de l'axe X, Y, et les directions de rotation sont obtenues à partir de la déviation de position d'un point central de composant par rapport à un point d'attraction de composant de la buse d'attraction (21) et une déviation de l'angle de rotation.

6. Machine de montage de composant comprenant une unité de tête déplaçable (5) supportant au moins une buse d'attraction (21, 22) pour attirer par aspiration des composants (20A, 20B) devant être montés en une position prédéterminée sur un substrat (3), en particulier sur une plaquette de circuits imprimés, un système de détection d'état attiré de composant ayant une unité laser (31) à titre de moyens de détection optiques et des moyens photographiques (33, 35), qui peuvent être utilisés sélectivement d'après le type de composants (20A, 20B) à monter, lesdits moyens photographiques comprenant une caméra de reconnaissance de composant (33), et un pilote principal (50) comprenant un processeur principal (53) adapté pour sélectionner l'unité laser (31) ou ladite caméra de reconnaissance de composant (33), en particulier pour mettre en oeuvre le procédé selon la revendication 1, caractérisé en ce que lesdits moyens photographiques comprennent en outre des moyens d'aide photographique (35) déplaçables, ledit processeur principal (53) est adapté pour sélectionner ladite caméra de reconnaissance de composant (33), dans le cas où lesdits composants (20A) devant être montés présentent des tiges conductrices, et pour envoyer un signal de commande afin de déplacer lesdits moyens d'aide photographique (35) déplaçables, de manière qu'un trou traversant (39) ménagé dans lesdits moyens d'aide photographique (35) soit positionné afin de loger ladite au moins une buse (21), dans cette position, lesdits moyens d'aide photographique (35) déplaçables constituant au moins partiellement un arrière-plan pour ledit composant (20A) à photographier, et en ce que ledit processeur principal (53) est adapté pour sélectionner ladite unité laser (31) d'après les autres types de composants (20B) à monter.

7. Machine de montage de composant selon la revendication 6, caractérisée en ce que lesdits moyens d'aide photographique (35) sont disposés sur l'unité de tête (5), lesdits moyens d'aide photographique (35) comprenant une unité d'émission de faisceaux lumineux déplaçable, ayant un émetteur lumineux (36) en forme de plaque, constitué d'une pluralité de LED, une plaque de diffusion (37) positionnée sur l'émetteur lumineux (36), adaptée pour émettre une lumière diffusée dans une direction allant vers le composant (20A, 20B) et lesdits moyens photographiques (33) étant susceptibles d'être disposés derrière le composant pendant qu'il est photographié, et un organe de montage (38) pour combiner l'émetteur lumineux (36) et la plaque de diffusion (37).

8. Machine de montage de composant selon la revendication 6 ou 7, caractérisée en ce que ladite caméra de reconnaissance de composant (33) est disposée sur une base (1) de la machine et peut être orientée vers un côté inférieur du composant (20A) opposé auxdits moyens d'aide photographique (35) pour photographier ledit composant (20A).

9. Machine de montage de composant selon la revendication 6, caractérisée en ce que ladite unité d'émission de lumière (36) desdits moyens d'aide photographique (35) est disposée sur une base (1) de la machine, et une plaque de diffusion (37) installée sur l'unité de tête (5) constitue au moins partiellement ledit arrière-plan pour la photographie dudit composant (20A).

10. Machine de montage de composant selon au moins l'une des revendications 6 à 9 précédentes, caractérisée en ce que ladite unité de tête (5) comprend au moins une première buse d'attraction (21) et au moins une seconde buse d'attraction (22), ladite première buse d'attraction (21) étant utilisable exclusivement lorsque lesdits moyens photographiques (35) sont sélectionnés pour détecter l'état attiré du composant (20A).

11. Machine de montage de composant selon au moins l'une des revendications 6 à 10 précédentes, caractérisée en ce qu'un système de commande est prévu, comprenant le pilote principal (50) ayant un circuit d'attaque de contrôleur d'axe (51), des moyens d'entrée/sortie (52), le processeur principal (53) et une section de traitement d'image (54) reliée à la caméra de reconnaissance de composant (33).
